# EUROPÄISCHE PATENTSCHRIFT

(11) **EP 1 352 424 B1**
(45) Veröffentlichungstag und Bekanntmachung des Hinweises auf die Patenterteilung: **28.11.2007**
(21) Anmeldenummer: 01984691.4
(22) Anmeldetag: 12.12.2001
(51) Int. Cl.: H01L 23/047

(54) **VERFAHREN ZUR MONTAGE EINES HALBLEITERBAUELEMENTS IN EIN GEHÄUSE**
METHOD FOR MOUNTING A SEMICONDUCTOR COMPONENT IN A HOUSING
PROCEDE DE MONTAGE D'UN ELEMENT A SEMI-CONDUCTEURS DANS UN BOITIER

(30) Priorität: 11.01.2001 DE 10100882
(43) Veröffentlichungstag der Anmeldung: 15.10.2003
(73) Patentinhaber: ROBERT BOSCH GMBH, 70442 Stuttgart (DE)
(72) Erfinder: WOLF, Kuno, 72417 Jungingen (DE); WALLRAUCH, Alexander, 72810 Gomaringen (DE); MEINDERS, Horst, 72762 Reutlingen (DE); GOEBEL, Vesna, 72766 Reutlingen (DE)
(86) Internationale Anmeldenummer: PCT/DE2001/004660
(87) Internationale Veröffentlichungsnummer: WO 2002/056371

(56) Entgegenhaltungen:
- DE-A- 19 549 202
- DE-A- 19 960 013
- US-A- 4 420 767
- US-A- 4 510 677
- US-A- 5 883 424

## Beschreibung

### Stand der Technik

Es sind Halbleiterbauelemente, insbesondere Dioden, bekannt, zum Beispiel aus US-A-5883424, bzw. DE-A-19960013, bei denen der Diodenchip nach dem Lackieren durch Vergießen mit einer Epoxydvergußmasse umhüllt wird. Dabei treten folgende Mängel auf: Es gibt Fehllackierungen und Vergießlunker, sodass zum einen nicht alle Chipkanten vollständig mit Lack überzogen sind und zum anderen die Vergießlunker zum Teil an Stellen der Fehllackierung, zum Teil in den Nischen und Hinterschneidungen auftreten. Solche Fehlstellen können grundsätzlich auch mit einem Kurzscreening nicht erkannt werden. Sie sind ein Qualitätsrisiko, da die in der Lack- bzw. Vergießblase eingeschlossenen Substanzen (Wasser, Essigsäure, Lösungsmittel) auf Dauer das Verhalten des Halbleiterbauelementes beeinträchtigen können. Weiterhin migriert Lot bei Temperaturbelastung und Temperaturwechseln in die Vergieß- bzw. Lacklunker und führt zum Kurzschluß. Ein weiteres Problem betrifft die Vergußmasse: Sie ist zu einem hohen Prozentsatz mit Quarzfüllern angereichert, sodass sich Sedimentationsprobleme ergeben, wenn zwischen Vergießen und Ausheizen des Bauelementes zu lange gewartet wird. Hierbei sedimentieren die Quarzfüller in der Vergußmasse. Wegen der unterschiedlichen Ausdehnung kann es dann zum Riß des Vergußkörpers und zum Feldausfall insbesondere bei Temperaturbelastung und bei Temperaturwecheln kommen. Wegen des schwierigen Fügeprozesses treten weiterhin Sperrstromausfälle durch Chiprisse und Lotkurzschlüsse auf. Somit wird ein Zwischenmessen der Dioden vor dem Vergießen erforderlich, was zu Verlusten führt. Weiterhin wird die Diode nach Beendigung des Montage- und Ausheizprozesses als Schüttgut gefördert und gemessen, wodurch weitere Verluste auftreten.

### Vorteile der Erfindung

Das erfindungsgemäße Verfahren und das erfindungsgemäße Halbleiterbauelement gemäß den nebengeordneten Ansprüchen haben dem gegenüber den Vorteil, dass durch ein Moldverfahren die Vergußmasse den Chip vollständig und lunkerfrei umschließt. Bei Verwendung eines speziellen Diodentypes kann der Lackierschritt weggelassen werden. Die Lunker werden beim Molden dadurch vermieden, dass bei der Moldtemperatur von etwa 170 °C und von Drücken von etwa 60 bis 80 bar die sehr niederviskose Moldmasse alle Kavitäten vollständig ausfüllt. Durch die in den Unteransprüchen aufgeführten Maßnahmen sind vorteilhafte Weiterbildungen und Verbesserungen des in den nebengeordneten Ansprüchen angegebenen Verfahrens und des Halbleiterbauelementes möglich.

### Zeichnung

Ausführungsbeispiele der Erfindung sind in der Zeichnung dargestellt und in der nachfolgenden Beschreibung näher erläutert. Es zeigen
Figur 1 ein zur Durchführung des Moldverfahrens vormontiertes erfindungsgemäßes Halbleiterbauelement,
Figur 2 ein erfindungsgemäßes Leadframe mit zwei Anschlußstücken gemäß einer ersten Ausführungsform der Erfindung,
Figur 3 zwei Anschlußstücke gemäß der ersten Ausführungsform der Erfindung,
Figur 4 die schematische Darstellung des Prozeßschrittes "Auflöten des Anschlußplättchens" im Lötkanal,
Figur 5 ein Leadframe einer zweiten Ausführungsform der Erfindung,
Figur 6 ein zur Durchführung des Moldverfahrens vormontiertes Halbleiterbauelement gemäß der zweiten Ausführungsform der Erfindung,
Figur 7 ein Leadframe, ein Halbleiterbauelement und ein oberes Anschlußplättchen und
Figur 8 eine Draufsicht eines Leadframes.

### Beschreibung des 1.Ausführungsbeispieles:

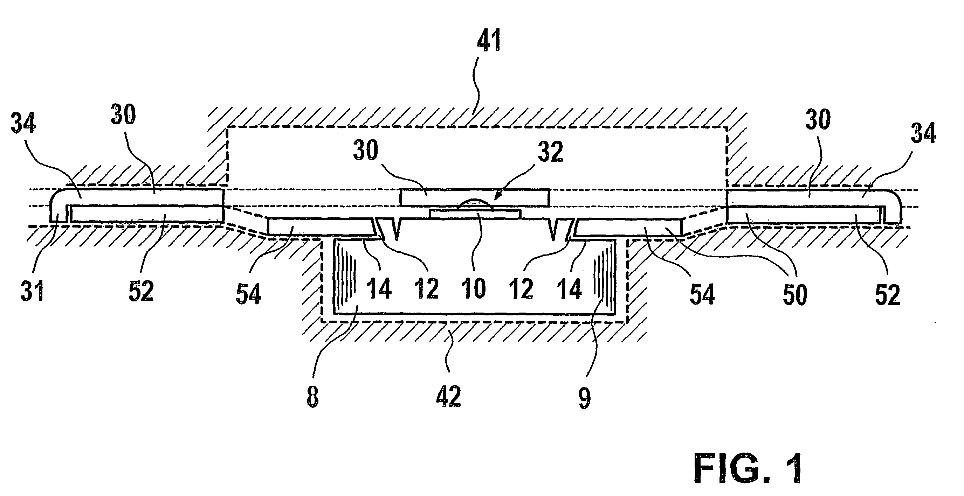

In Figur 1 ist ein zur Durchführung des Moldverfahrens vormontiertes Halbleiterbauelement 10 in vormontiertem Zustand gemäß einer ersten Ausführungsform der Erfindung dargestellt. Das Halbleiterbauelement 10 und die obere Lötform (Preform) wurde in einem ersten Lötprozeß auf einen Sockel 8 aufgelötet. Im oberen Bereich des Sockels 8 ist am Sockelrand ein Einzug 14 vorhanden, in den der innere Ring 54 eines Leadframes 50 eingefügt werden kann. An dieser Stelle hat der Sockel 8 eine Hinterschneidung 12. Zur Befestigung von Leadframe 50 und Sockel 8, der im folgenden auch als Diodensockel 8 bezeichnet wird, verstemmt ein in der Zeichnung nicht dargestelltes Ringmesser bei der Montage des Halbleiterbauelements 10 Kupfer in der Nähe der Hinterschneidung 12 gegen den inneren Leadframering 54. Diese Verbindung dient nur zur Abdichtung beim Molden und zur mechanischen Stabilität beim Auflöten des Leadframes auf die obere Preform. Sie dient nicht zur Stromleitung. In Figur 1 sind ferner durch Schrägschraffierung die Begrenzungslinien der oberen 41 und der unteren 42 Moldform dargestellt. An der Unterseite des inneren Leadframerings 54 wird ein zweiter Moldformteil 42 einer in der Zeichnung nicht ausdrücklich bezeichneten Moldform nach unten zum Diodensockel 8 hin abgedichtet. Weil die Diode als Einpressdiode verwendet wird, hat der Sockel 8 in seinem Mantelbereich, d. h. entlang seines Umfangs, eine Rändelstruktur, die in der Zeichnung mit senkrechten Strichen 9 angedeutet ist. Eine Abdichtung der Moldform an der Rändelstruktur 9 des Diodensockels 8 ist nicht möglich. Die Abdichtung beim Molden erfolgt zwischen dem am Diodensockel verstemmten inneren Leadframering 54 und seiner Auflage auf der unteren Moldform 42 und durch das Zusammendrücken der beiden äußeren Leadframeringe 30 und 52.

Hierzu umfaßt der Sockel 8 im Bereich seines Einzugs 14 einen ersten, in der Zeichnung nicht näher bezeichneten Bereich, der auf einen zweiten, in der Zeichnung ebenfalls nicht näher bezeichneten Bereich des inneren Leadframerings 54 gedrückt wird, und so die Abdichtung zwischen dem Sockel 8 und dem inneren Leadframering 54 bewerkstelligt. Der erste und der zweite Bereich sind erfindungsgemäß im wesentlichen ringförmig vorgesehen.

Der Leadframe 50 umfaßt weiterhin einen äußeren Leadframering 52, der ebenfalls auf dem zweiten Moldformteil 42 aufliegt. Zum vorderseitigen Anschluß des Halbleiterbauelementes 10 wird auf den Leadframe 50 ein Anschlußstück 30 gelegt, welches erfindungsgemäß ein Anschlußplättchen 32 aufweist. Das Anschlußstück 30 wird dabei so auf dem Leadframe 50 positioniert, dass das Anschlußplättchen 32 im Bereich des Halbleiterbauelementes 10 positioniert wird. Zwischen dem Halbleiterbauelement 10 und dem Anschlußplättchen 32 befindet sich Lot, insbesondere in Form einer Lötfolie, so dass während eines Lötvorgangs das Anschlußplättchen 32 mit dem Halbleiterbauelement 10 verlötet werden kann. Das Anschlußstück 30 weist darüber hinaus einen äußeren Ring 34 auf, der beim Auflegen des Anschlußstücks 30 auf den Leadframe 50 im Bereich des äußeren Leadframeringes 52 positioniert wird. Das Anschlußstück 30 und insbesondere also das Anschlußplättchen 32 besteht aus beidseitig vernickeltem, 1 mm dickem Kupfer. Das Anschlußstück 30 weist zwei 25 mm lange, 2 mm breite Anschlußarme 36 auf. Es ist für den Einsatz des Halbleiterbauelementes 10, insbesondere den Einsatz als Dioden, vorteilhaft, dass zwei Anschlußarme 36 vorhanden sind. Insbesondere bei einer Weiterverarbeitung eines als Diode zur Benutzung in Generatoren ausgebildeten Halbleiterbauelementes 10 kann einer der Anschlußarme 36 für die Verbindung mit der Erregerdiode und der andere der Anschlußarme 36 für den Generatorfeldanschluß verwendet werden. Man vermeidet dadurch gleichzeitig, daß zwei Anschlüsse des Generators mit einem einzigen Anschluß eines Halbleiterbauelementes verbunden werden.

Der äußere Ring 34 des Anschlußstückes 30 stellt sicher, dass während des Moldverfahrens eine erste Teilmoldform 41 gegenüber der zweiten Teilmoldform 42 nach außen hin abgedichtet werden kann. Mit einer Breite von etwa 1 mm ist dieser Ring selbst bei einer Fehljustage deckungsgleich mit dem äußeren Leadframering 52. Zur weiteren Verbesserung der Positionierung des Anschlußstücks 30 auf dem Leadframe 50 ist weiterhin optional eine weitere Fügehilfe vorgesehen, die in Form von nach unten, d. h. zum Leadframe 50 hin gerichteten Krallen 31 am Anschlußstück 30 ausgebildet ist. Dadurch kommen keine extremen Fehljustagen vor.

Weiterhin ist in Figur 1 sichtbar, dass der innere Leadframering 54 gegenüber dem äußeren Leadframering 52 um die kumulierte Bauhöhe aus dem Halbleiterbauelement 10 und den beiden Lötschichten zwischen dem Halbleiterbauelement 10 und dem Anschlußplättchen 32 einerseits und dem Halbleiterbauelement 10 und dem Sockel 8 andererseits abgesenkt wird. Diese Bauhöhe entspricht ca. 240 bis 360 µm. Hierdurch wird erreicht, dass sich beim Löten des Anschlußstücks 30 bzw. des Anschlußplättchens 32 auf die Chipoberseite des Halbleiterbauelementes 10 ein Spalt dieser Größe zwischen dem Diodensockel 8 und der Unterseite des Anschlußplättchens 32 zur Aufnahme des Chips, d. h. des Halbleiterbauelementes 10, und zweier Lötschichten bilden kann.

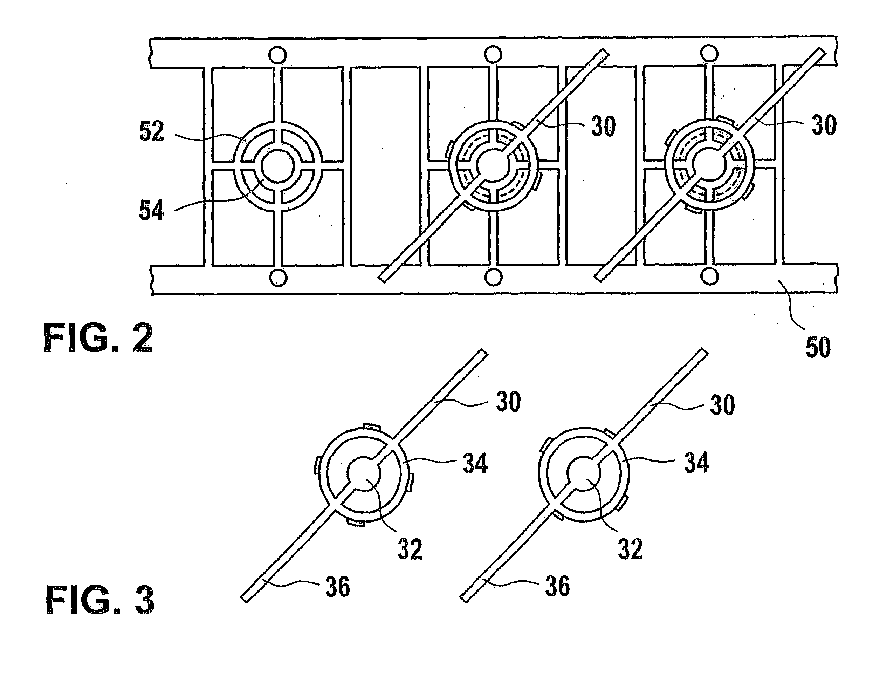

In Figur 2 ist das Leadframe 50 als fortlaufender Metallstrang in Draufsicht dargestellt, wobei drei mögliche Positionen zur Montage des Halbleiterbauelementes 10 dargestellt sind. An der am weitesten links dargestellten Position ist das Leadframe 50 "leer" dargestellt, d. h. ohne aufgelegtes Anschlußstück 30. An der mittleren Position und der rechten Position ist das Leadframe 50 mit aufgelegtem Anschlußstück 30 dargestellt. Erkennbar ist jeweils der innere Leadframering 54 und der äußere Leadframering 52. Der äußere Leadframering 52 ist mit je vier Anschlußstegen mit dem inneren Leadframering 54 und mit den restlichen Bereichen des Leadframes verbunden. Wie bereits beschrieben dichtet der äußere Leadframering 52 mit dem deckungsgleichen äußeren Ring 34 des Anschlußstücks 30 die aus dem ersten Moldformteil 41 und dem zweiten Moldformteil 42 gebildete Moldform nach außen hin ab. Die Niveauabsenkung des inneren Leadframeringes 54 gegenüber dem äußeren Leadframering 52 ist mit einer Genauigkeit von +-30 µm möglich. Die Niveaueinstellung des Sockels 8 gegenüber dem Einzug 14 ist mit einer Genauigkeit von ebenfalls +-30 µm möglich, so dass sich eine Gesamttoleranz von +-60 µm ergibt, was zu einer Einzellot-Dickenschwankung von 20 bis 80 µm führt, wenn von einer Chipdicke des Halbleiterbauelementes 10 von etwa 200 µm ausgegangen wird. Diese Einzellot-Dickenschwankung liegt in tolerierbaren Bereichen.

In Figur 3 ist das Anschlußstück 30 mit dem Anschlußplättchen 32, dem äußeren Ring 34 und den Anschlußarmen 36 dargestellt. Es zeigt sich, dass bei der Verwendung des Halbleiterbauelementes 10 als Diode selbst bei einer Belastung von 200 Ampere mit 4 x 300 µm dicken Aluminium-Bonddräten kaum ein Flußspannungsunterschied gegenüber herkömmlichen ZR-Dioden mit einem Kopfdraht als Anschluß festzustellen ist.

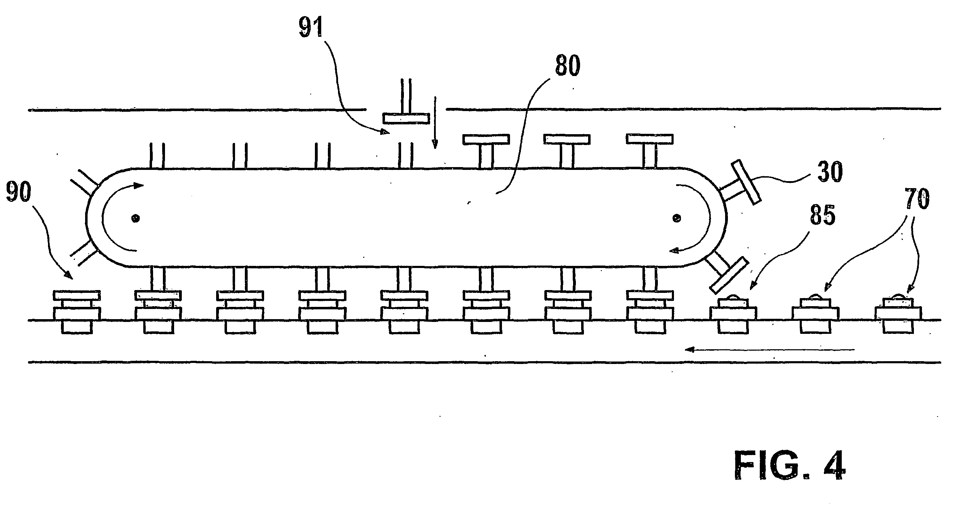

In Figur 4 ist eine schematische Darstellung eines Lötkanals einer ESEC-Maschine dargestellt. Es wird das Auflöten des Anschlußstücks 30 dargestellt. Mit einem Saugwerkzeug 80 werden gestapelte Anschlußstücke 30 gefördert und auf das vormontierte Halbleiterbauelement 10 gelegt. Das vormontierte Halbleiterbauelement 10 mit dem Leadframe 50 wird dabei als Preform 70 bezeichnet. Das angesaugte Anschlußstück 30 trifft an einer ersten Position 85 auf die Preform 70 und wird dort abgelegt und niedergehalten, bis an einer zweiten Position 90 das Lot soweit abgekühlt ist, dass die Ansaugung abgeschaltet werden kann. Zur Förderung des Anschlußstücks 30 zur Preform 70 wird hierbei ein umlaufendes Band verwendet. Nach dem Verlassen der zweiten Position 90 kehrt das Band leer wieder an eine dritte Position 91 zurück, wo das Band neu mit Anschlußstücken 30 bestückt wird. Das Band ist nicht näher mit einem Bezugszeichen bezeichnet. Durch die Verwendung des Saugwerkzeugs 80 ist sichergestellt, dass alle Anschlußstücke 30 flach mit ihren äußeren Ringen 34 auf dem Leadframe liegen. Der Spalt zwischen den zu verlötenden Oberflächen wird erfindungsgemäß so klein gewählt, dass sich beim Löten ein Kapillareffekt ergibt. Dies ist insbesondere zwischen der Oberfläche des Halbleiterbauelementes 10 und dem Anschlußplättchen bzw. der Unterseite des Halbleiterbauelementes 10 und der Oberfläche des Sockels 8 gegeben. Dadurch werden gleichmäßige und gute Lötungen erreicht. Die Anschlußarme 36 des Anschlußstücks 30 sind auf dem Leadframe 50 um 45 ° versetzt. Alternativ ist es auch denkbar, dass die Anschlußarme 36 außerhalb des äußeren Rings 34 nach oben abgewinkelt werden. Damit sind sie quer zur Leadframe-Längsrichtung montierbar. Auch in dieser Form sind die Anschlußstücke 30 stapelbar und automatisch förderbar. Um einen Lotauslauf in den äußeren Ring 34 zu vermeiden, ist es vorteilhaft, die Anschlußstücke 30 partiell zu vernickeln. Hierbei wird Nickel nur im inneren Bereich, d. h. im Bereich des Anschlußplättchen 32 sowie an den Anschlußarmen 36 auf das Anschlußstück 30 aufgebracht.

Die genaue Formgestaltung der Moldmatrix, d. h. der Moldmasse in dem Bereich zwischen den beiden Ringen des Leadframes 50, d. h. zwischen dem inneren Leadframering 54 und dem äußeren Leadframering 52, muß so erfolgen, dass möglichst wenig Moldmasse in diesen Zwischenraum eindringen kann. Zur Fertigstellung der Montage des Halbleiterbauelementes 10 nach der Durchführung des Moldverfahrens wird das Halbleiterbauelement 10 freigestanzt. Das hierbei entstehende Produkt wird ebenfalls als Halbleiterbauelement im weiteren Sinne bezeichnet, obwohl es sowohl den Halbleiterchip (= Halbleiterbauelement im engeren Sinne) als auch das "Gehäuse", bestehend hauptsächlich aus der Moldmasse, umfaßt. Hierbei kann es vorteilhaft sein, das Freistanzen partiell nur an den Anschlußarmen 36 durchzuführen, sodass das Halbleiterbauelement 10 weiterhin im Leadframeverbund bleibt. Dadurch wird ermöglicht, dass eine Endmessung des Halbleiterbauelementes 10 im Leadframestrang möglich ist. Man muß also die Halbleiterbauelemente 10 nicht aus dem Schüttgut heraus wieder einrütteln. Kontaktiert wird bei dieser Endmessung zwischen dem Leadframe und den Anschlußarmen 36. Hierbei würde die Verbindung zwischen dem Sockel 8 und dem inneren Leadframering 54 auch als elektrisch leitender Übergang genutzt. Im Betrieb des Halbleiterbauelementes 10 würde dies jedoch nicht mehr der Fall sein. Die Endmessung des Halbleiterbauelementes 10 im Leadframeverband setzt eine galvanische Verzinnung vor dem partiellen Freistanzen voraus.

Nach dem Moldverfahren wird das montierte Halbleiterbauelement ausgeheizt, was jedoch ein Standardprozess ist.

Durch die flache Form der Oberseite des montierten Halbleiterbauelementes 10 gemäß der Erfindung ist eine kostengünstige Laserbeschriftung möglich.

Wenn der Einbau des montierten Halbleiterbauelementes 10 durch Einpressen in ein Gerät, beispielsweise einen Generator, vorgesehen ist, erfolgt dieses Einpressen von der Moldmassenseite her. Hierbei darf jedoch der Einpressweg nicht über den Bereich des verstemmten inneren Leadframerings 54 hinausgehen.

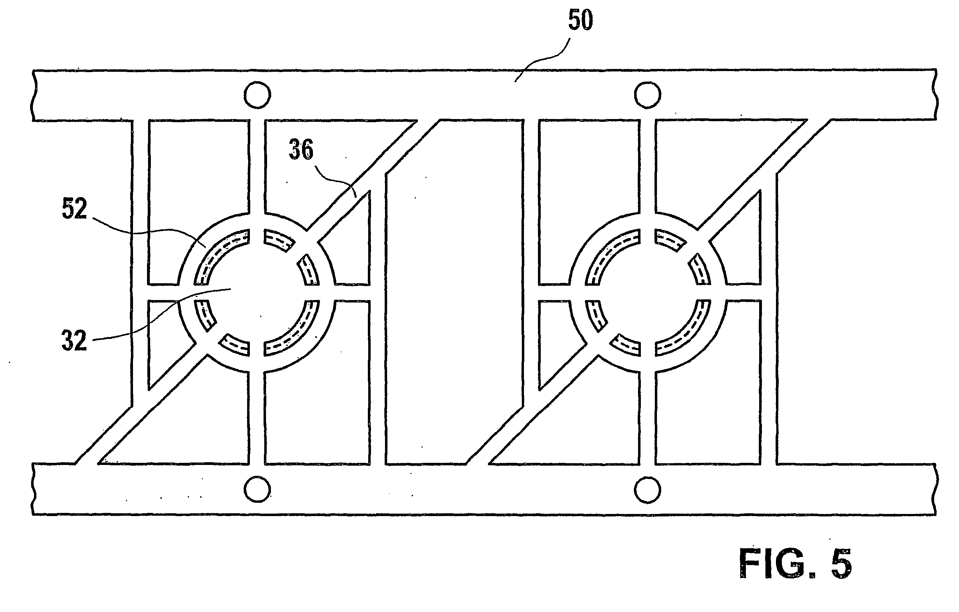

In Figur 5 ist ein Leadframe 50 einer zweiten Ausführungsform der Erfindung dargestellt. Hierbei ist das Anschlußstück 30 und das Leadframe 50 einstückig ausgeführt. Dadurch umfaßt das Leadframe 50 das Anschlußplättchen 32 sowie den äußeren Leadframering 52.

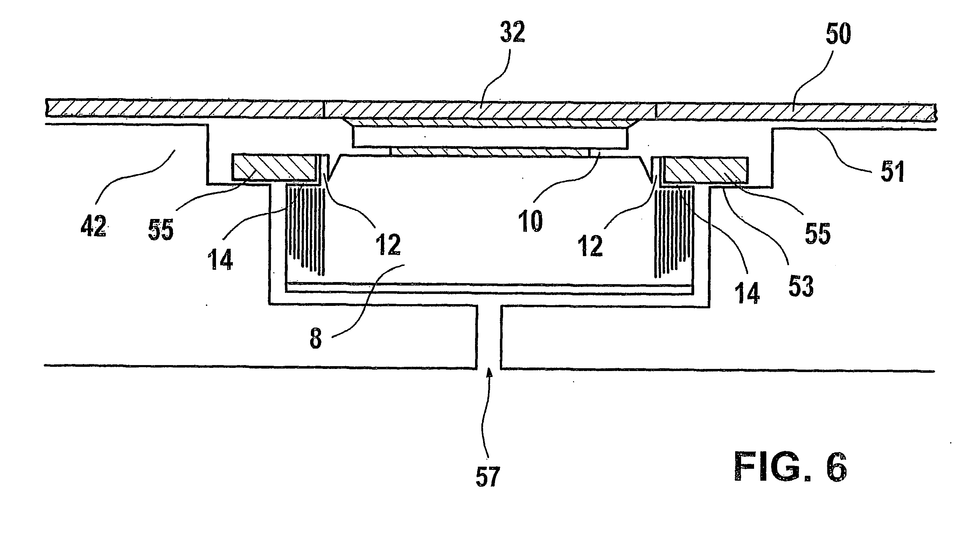

In Figur 6 ist ein Halbleiterbauelement 10 in vormontiertem Zustand gemäß der zweiten Ausführungsform der Erfindung dargestellt. Hierbei wird der Sockel 8, das Halbleiterbauelement 10, das Anschlußplättchen 32 und die Anschlußarme 36 noch einfacher und kostengünstiger zusammengefügt. Das anschließende Umspritzen mit einem Duroplastkunststoff (Molden) ist dann wieder wie bei der ersten Ausführungsform möglich. Es wird, wie bei Figur 5 bereits beschrieben, ein geändertes Leadframe 50 verwendet. Dieses Leadframe 50 enthält das Kopfanschlußplättchen 32, die Anschlußarme 36 und den äußeren Leadframering 52. Die gesonderte Einfügung des Anschlußstücks 30 als Einlegeteil entfällt somit. Das Leadframe 50 ist im Gegensatz zur ersten Ausführungsform der Erfindung plan und kann beispielsweise 1 mm dick sein. Wie bisher befindet sich um das Anschlußplättchen 32 der äußere Leadframering 52 als konzentrischer Ring der den ersten, in Figur 6 nicht dargestellten Moldformteil und den zweiten Moldformteil 42 beim Molden gegeneinander abdichtet. Die Abdichtung mittels zweier aufeinanderliegenden Ringe wie bei der ersten Ausführungsform der Erfindung entfällt damit.

Mit Hilfe einer ESEC-Lötmaschine mit zwei Wire dispensern wird die erste Preform auf das Leadframe 50 gebracht, das Halbleiterbauelement 10 aufgesetzt und anschließend die zweite Preform auf die Chiprückseite gebracht. Die Preform ist eine Lotform, die in Form eines Lottropfens auf die Leadoberfläche aufgebracht wird, die eine kissenartige Oberfläche hat und auf die der Chip gedrückt wird, (die attach). Die erste Preform versorgt das Lot für die untere Lötung, die zweite Preform versorgt das Lot für die obere Lötung.

Der Sockel 8 wird als Einlegeteil verwendet. Seine Form ist gegenüber der in Figur 1 angegebenen Form lediglich dadurch geändert, dass sich der Sockel 8 zu seinem unteren Ende hin, d. h. zu der von dem Einzug 14 abgewandten Seite hin verjüngt und so eine leicht konische Form ergibt. Dadurch ist eine Einpressung des Sockels 8 in Richtung seiner Unterseite möglich. Im Gegensatz zur ersten Ausführungsform wird bei der zweiten Ausführungsform der Erfindung anstelle des inneren Leadframeringes 54 ein Ring 55 vorgesehen. Der Ring 55 ist mit einer nach innen gerichteten Anschrägung versehen und mit einem nicht dargestellten Ringmesser, insbesondere gegen die Hinterschneidung 12 des Sockel 8, verstemmt. Die solchermaßen präparierten Sockel 8 werden in die Vertiefungen einer Vakuumlötofenform eingelegt. Sie liegen mit den verstemmten Ringen auf einer Kante 53 der Lötform auf. Auf die Sockel 8 wird das um 180 ° gewendete Leadframe 50 gelegt und mit Passtiften in Führungslöcher positioniert. Der Abstand zwischen einem Leadframeanschlag 51 und der Kante 53 definiert einen Spalt zwischen der Oberseite des Sockels 8 und der Unterseite des Anschlußplättchens 32. Dieser Spalt wird vom Halbleiterbauelement 10 und zwei Lotschichten ausgefüllt.

Um ein gleichmäßiges und sicheres Anliegen der ganzen Leadframefläche am Anschlag 51 zu bewirken, wird auf den Leadframe 50 eine in der Regel mindestens 4 mm dicke, Stahlschiene gelegt, die auch mit den Führungsstiften der Lötofenform verstiftet ist.

Die erste Lötofenfahrt umfaßt das Aufbringen der ersten Preform, dem Auflegen des Chips und dem Aufbringen der zweiten Preform in der ESEC-Maschine. Die zweite Lötofenfahrt kann in einem Durchlauf-Vakuumlötofen erfolgen. In der Lötofenform befinden sich unter dem Diodensockel 8 Bohrungen 57. In diese Bohrungen 57 werden nach der Vakuumlötofenfahrt Auswerferstifte eingeführt, mit denen das Leadframe 50 gleichmäßig aus der Lötform heraus gedrückt werden kann.

Alle weiteren Prozesse, wie Molden, Verzinnen, Freistanzen etc. werden gemäß der Beschreibung der ersten Ausführungsform der Erfindung durchgeführt. Ein Vorteil gegenüber der ersten Ausführungsform der Erfindung besteht darin, dass die Endmessung der Halbleiterbauelemente 10 im vollen Leadframeverbund erfolgen kann. Ein partielles Freistanzen der Anschlußplättchen 32 kann entfallen. Als ein Anschluß des Halbleiterbauelementes kann das komplette, nicht freigestanzte Leadframe und als weiterer Anschluß die Sockelrückseite verwendet werden.

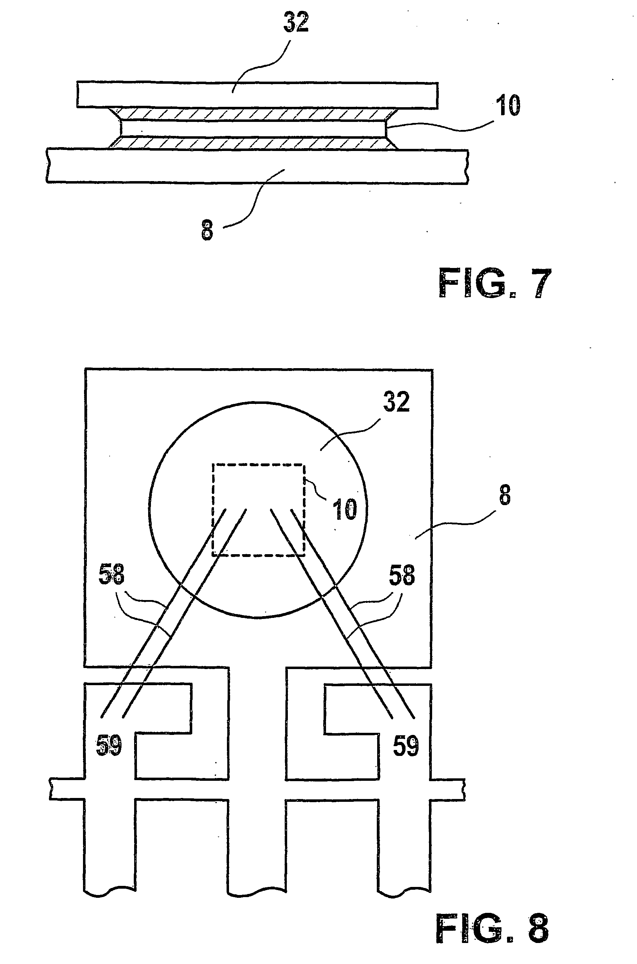

Eine dritte Ausführungsform der Erfindung ist in Figur 7 und 8 dargestellt: Hierbei wird ein Standardtransistorgehäuse, beispielsweise ein TO218 Gehäuse (mit drei Anschlüssen) zur Aufnahme eines Diodenchips als Halbleiterbauelement 10 verwendet. Figur 8 zeigt ein solches Leadframe 8 und ein oberes Diodenanschlußplättchen 32, welches für eine gute Stromtragfähigkeit für Maximalströme beispielsweise von 200 A mit 4 Bonddrähten, hiervon 2 mit dem linken Anschlusspad und 2 mit dem rechten Anschlusspad, verbunden wurden. In Figur 7 ist ein Leadframe 8, der Diodenchip 10 und das obere Anschlußplättchen 32 dargestellt. Die beiden Chiplötungen sind auch hier beispielsweise mit einem Standard-Lötverfahren, etwa dem Soft-Solder-Die-Attach-Verfahren, durchgeführt. Bei der dritten Ausführungsform der Erfindung sind an dem Gehäuse, das den Halbleiterchip, bzw. das Halbleiterbauelement 10, aufnimmt, Anschlusspads 59 vorgesehen. Die elektrische Verbindung des oberen Diodenplättchens mit den Anschlusspads 59 kann mit Aluminiumdickdrahtbonds 58 erfolgen. Hier können vorzugsweise Bonddrähte mit Durchmessern von 300 µm oder 500 µm verwendet werden. Der Moldvorgang, das Ausheizen, das Verzinnen der Beinchen und das Freistanzen der einzelnen Dioden sind Standardprozesse und können wie in den vorhergehenden Ausführungsformen der Erfindung beschrieben, durchgeführt werden.

Der üblicherweise am Mittelstift des dreipoligen TO218-Sockels vorhandene Rückseitenanschluss kann entweder abgestanzt werden, oder er kann als Sense-Kontakt des unteren Diodenanschlusses verwendet werden. Natürlich ist diese im TO218-Gehäuse gemoldete Diode nicht als Einpressdiode einsetzbar. Um solche Dioden trotzdem im Generator eines Kraftfahrzeuges im Diodengruppenteil mit jeweils 3 Plus- und 3 Minus-Hauptstromdioden verwenden zu können, kann man die Rückseite des TO218-Leadframes mit einer Zinn/Blei-Oberfläche (SN/Pb15) galvanisch beschichten und im Reflowverfahren auf den Kühlflansch des Diodengruppenteils des Generators auflöten.

Bei der dritten Ausführungsform werden die beiden äußeren Anschlüsse gemeinsam zum Anschluss des oberen Diodenkontaktes und der mittlere Anschluss, der mit der Hauptfläche des Leadframes 8 verbunden ist, zum Anschluss des unteren Diodenkontaktes verwendet. Der Anschluss kann entfallen, weil vorwiegend die Hauptfläche zum Anschluss des unteren Diodenkontaktes verwendet wird. Bei Verwendung eines einpoligen TO-Gehäuses ist der Mittelstift von der Hauptfläche getrennt.

Figur 8 zeigt den Ausschnitt eines TO218-Leadframes mit 3 Anschlüssen und das obere Diodenanschlussplättchen, welches für eine gute Stromtragfähigkeit (gefordert sind Maximalströme von 200 A) mit 4 Aluminium-Bonddrähten, 2 mit dem linken Anschluss 59 und 2 mit dem rechten Anschluß verbunden wurde. Die Auflötung des oberen Diodenplättchens 32 auf die obere Chipoberfläche kann entweder in einem zweiten Lötverfahren im Vakuumdurchlaufofen erfolgen, oder, wie in der ersten Ausführungsform angegeben, in einem modifizierten Soft-Solder-Die-Attach-Verfahren erfolgen. Die Bonddrähte können mit einem speziellen Bondgerät (Bonder) angebracht werden. Weil Bonder sehr teuer sind und somit das Produkt erheblich verteuern, wird in Figur 8 alternativ eine Möglichkeit angegeben, bei der keine Bonddrähte benötigt werden. Dafür wird das obere Anschlussplättchen 32 mit zwei Anschlussärmchen versehen. Das Anschlussplättchen wird somit gleichzeitig mit der oberen Metallisierung der Diode und mit den beiden Leadframeanschlüssen 59 verbunden. Zur Vereinfachung des Lötvorganges kann das Anschlussplättchen einseitig mit einer Blei/Zinn-Oberfläche beschichtet werden. Somit entfallen die Lötfolien zum Anlöten der Diodenvorderseite und der Anschlussbeinchen. Weil sich die Diodenvorderseite und die Anschlussflächen für die Anschlüsse 59 auf verschiedenen Niveaus befinden, ist es vorteilhaft, die Anschlussbeinchen des Anschlussplättchens 32 leicht abzuwinkeln.

## Patentansprüche

1. Verfahren zur Montage eines Halbleiterbauelementes (10) in ein Gehäuse, wobei das Gehäuse einen Sockel (8) umfasst, auf den das Halbleiterbauelement (10) aufgelötet wird und ein Anschlußstücks (30), das auf die Oberfläche des Halbleiterbauelements (10) aufgebracht wird und das Halbleiterbauelement (10) mittels eines Moldverfahrens zumindest teilweise mit der Moldmasse umgeben wird, wobei ein Leadframes (50) vorgesehen ist, zur Abdichtung gegenüber einer Moldform (41, 42) und der Leadframe (50) wenigstens einen Leadframering (54) aufweist, der auf einen Einzug (14) im Randbereich des Sockels (8) aufgebracht und mit diesem durch verstemmen fixiert wird und der Leadframes (50) einen äußeren Leadframering (52) umfasst, der mit einem äußeren Ring (34) des Anschlußstücks (30) zusammenwirkt.

2. Verfahren nach Anspruch 1, **dadurch gekennzeichnet, dass** die Verstemmumg des Leadframerings (54) mit dem Sockel (8), der eine Hinterschneidung (12) aufweist, mittels eines Ringmessers erfolgt, das Kupfer in der nähe der Hinterschneidung (12) gegen den inneren Leadframering drückt und bei der Montage die zueinander gehörenden Ringbereiche aufeinandergedrückt werden.

3. Verfahren nach einem der vorhergehenden Ansprüche, **dadurch gekennzeichnet, dass** das Anschlußstück (30) ein Anschlußplättchen (32) und den äußeren Ring (34) aufweist und Bereiche gebildet werden durch zumindest einen Teil einer Seite des äußeren Rings (34) und durch zumindest einen Teil einer Seite des äußeren Leadframeringes (52).

4. Verfahren nach einem der vorhergehenden Ansprüche, **dadurch gekennzeichnet, dass** der innere Ring (54) des Leadframes (50) gegenüber dem dem äußeren Ring (52) des Leadframes (50) abgesenkt ist.

5. Verfahren nach Anspruch 1, **dadurch gekennzeichnet, dass** das Anschlußstück (30) einstückig mit einem Leadframe (50) verbunden ist und ein weiterer Ring (55) vorgesehen ist, wobei der Ring (55) mit dem der Sockel (8) verbunden wird, wobei am Rang des Sockels (8) ein Einzug (14) eingestanzt ist und der Sockel (8) eine Hinterschneidung (12) aufweist, und die Verbindung zwischen Sockel (8) und Ring (55) mittels eines Ringmessers erfolgt, das Kupfer in der Nähe der Hinterschneidung (12) gegen den Ring (55) drückt und bei der Montage die zueinander gehörenden Ringbereiche aufeinandergedrückt werden.

6. Verfahren nach einem der vorhergehenden Ansprüche, **dadurch gekennzeichnet, dass** das Anschlußstück (30) zwei Anschlußarme (36) aufweist, mittels derer das Halbleiterbauelement bei Verwendung als Diode bei einem Generator an vorgebbaren Anschlüsse des generators anschließbar ist.

7. Halbleiterbauelement (10) hergestellt gemäß eines Verfahrens nach einem der vorhergehenden Ansprüche, wobei das Halbleiterbauelement (10) in einem Gehäuse ist, das Gehäuse einen Sockel (8) umfasst, auf den das Halbleiterbauelement (10) aufgelötet ist und ein Anschlußstück (30), das auf die Oberfläche des Halbleiterbauelements (10) aufgebracht ist und das Halbleiterbauelement (10) zumindest teilweise mit Moldmasse umgeben ist, wobei ein Leadframe (50) vorgesehen ist, das die Abdichtung gegenüber einer Moldform (41, 42) bewirkt, **dadurch gekennzeichnet, dass** der Leadframe (50) wenigstens einen Leadframering (54) aufweist, der auf einen Einzug (14) im Randbereich des Sockels (8) aufgebracht und mit diesem durch verstemmen fixiert ist und der Leadframe (50) einen äußeren Leadframering (52) umfasst, der mit einem äußeren Ring (34) des Anschlußstücks (30) zusammenwirkt.

## Claims

1. Method for mounting a semiconductor component (10) into a housing, wherein the housing comprises a base (8), onto which the semiconductor component (10) is soldered, and a connection piece (30) which is applied to the surface of the semiconductor component (10), and the semiconductor component (10) is at least partly surrounded with the moulding compound by means of a moulding method, wherein a leadframe (50) is provided, for sealing relative to a mould (41, 42), and the leadframe (50) has at least one leadframe ring (54) which is applied to an indentation (14) in the edge region of the base (8) and is fixed with this by caulking, and the leadframe (50) comprises an outer leadframe ring (52), which interacts with an outer ring (34) of the connection piece (30).

2. Method according to Claim 1, **characterized in that** the caulking of the leadframe ring (54) with the base (8), which has an undercut (12), is effected by means of a ring cutter which presses copper in the vicinity of the undercut (12) against the inner leadframe ring, and the ring regions associated with one another are pressed onto one another during mounting.

3. Method according to one of the preceding claims, **characterized in that** the connection piece (30) has a connection laminar (32) and the outer ring (34) and regions are formed by at least one part of a side of the outer ring (34) and by at least one part of a side of the outer leadframe ring (52).

4. Method according to one of the preceding claims, **characterized in that** the inner ring (54) of the leadframe (50) is lowered relative to the outer ring (52) of the leadframe (50).

5. Method according to Claim 1, **characterized in that** the connection piece (30) is integrally connected to a leadframe (50) and a further ring (55) is provided, wherein the ring (55) is connected to the base (8), wherein an indentation (14) is stamped in at the edge of the base (8) and the base (8) has an undercut (12), and the connection between base (8) and the ring (55) is effected by means of a ring cutter which presses copper in the vicinity of the undercut (12) against the ring (55), and the ring regions associated with one another are pressed onto one another during mounting.

6. Method according to one of the preceding claims, **characterized in that** the connection piece (30) has two connection arms (36) by means of which the semiconductor component, when used as a diode in the case of a generator, can be connected to predeterminable connections of the generator.

7. Semiconductor component (10) produced in accordance with a method according to one of the preceding claims, wherein the semiconductor component (10) is in a housing, the housing comprises a base (8), onto which the semiconductor component (10) is soldered, and a connection piece (30) which is applied to the surface of the semiconductor component (10), and the semiconductor component (10) is at least partly surrounded with moulding compound, wherein a leadframe (50) is provided, which brings about the sealing relative to a mould (41, 42), **characterized in that** the leadframe (50) has at least one leadframe ring (54) which is applied to an indentation (14) in the edge region of the base (8) and is fixed with this by caulking, and the leadframe (50) comprises an outer leadframe ring (52), which interacts with an outer ring (34) of the connection piece (30).

## Revendications

1. Procédé de montage d'un composant semi-conducteur (10) dans un boîtier, ayant un socle (8) sur lequel est soudé le composant semi-conducteur (10) ainsi qu'une pièce de raccordement (30) sur la surface du composant semi-conducteur (10) et le composant semi-conducteur (10) est entouré au moins en partie d'une masse moulée, réalisée par un procédé de moulage,
une grille de connexion (50) prévue pour assurer l'étanchéité vis-à-vis du moule (41, 42) comporte au moins un anneau de cadre (54) appliqué sur une partie en retrait (14) de la zone de bord du socle (8) et bloquée par matage à celui-ci, le cadre de soudage (50) présentant un anneau extérieur (52) coopérant avec un anneau extérieur (34) de la pièce de raccordement (30).

2. Procédé selon la revendication 1,
**caractérisé en ce que**
le matage de l'anneau de la grille de connexion (54) avec le socle (8) qui comporte une partie en contre-dépouille (12), se fait à l'aide d'un couteau annulaire qui repousse le cuivre à proximité de la partie en contre-dépouille (12) contre l'anneau intérieur de la grille de connexion et au montage, les deux zones annulaires correspondantes sont pressées l'une contre l'autre.

3. Procédé selon l'une des revendications précédentes,
**caractérisé en ce que**
la pièce de raccordement (30) comporte une plaquette de raccordement (32) et un anneau extérieur (34) et elle forme des zones par au moins une partie d'un côté de l'anneau extérieur (34) et par au moins une partie d'un côté de l'anneau extérieur (52) de la grille de connexion.

4. Procédé selon l'une des revendications précédentes,
**caractérisé en ce que**
l'anneau intérieur (54) de la grille due connexion (50) est enfoncé par rapport à l'anneau extérieur (52) de la grille de connexion (50).

5. Procédé selon la revendication 1,
**caractérisé en ce que**
la pièce de raccordement (30) est reliée en une seule partie à la grille de connexion (50) et un autre anneau (55) est relié au socle (8),
le bord du socle (8) ayant une partie en retrait (14) réalisée par emboutissage et le socle (8) a une partie en contre-dépouille (12), la liaison entre le socle (8) et l'anneau (55) étant faite à l'aide d'un couteau annulaire qui repousse le cuivre à proximité de la partie en contre-dépouille (12) contre l'anneau (55) et au montage, les zones annulaires correspondantes sont pressées l'une contre l'autre.

6. Procédé selon l'une des revendications précédentes,
**caractérisé en ce que**
la pièce de raccordement (30) comporte deux branches de raccordement (36) à l'aide desquelles le composant semi-conducteur, utilisé comme diode d'un générateur, est relié à des branchements prédéfinis du générateur.

7. Composant semi-conducteur (10) fabriqué selon le procédé de l'une des revendications précédentes, selon lequel le composant semi-conducteur (10) est logé dans un boîtier ayant un socle (8) sur lequel est soudé le composant semi-conducteur (10) ainsi qu'une pièce de raccordement (30) appliquée à la surface du composant semi-conducteur (10) et le composant semi-conducteur (10) est entouré au moins en partie d'une masse moulée, une grille de connexion (50) étant prévue pour assurer l'étanchéité par rapport au moule (41, 42),
**caractérisé en ce que**
la grille de connexion (50) comporte au moins un anneau de grille de connexion (54) appliqué sur une partie en retrait (14) de la zone du bord du socle (8) en étant fixé à celui-ci par matage et la grille de connexion (50) a un anneau extérieur (52) coopérant avec un anneau extérieur (34) de la pièce de raccordement (30).
